Europäisches Patentamt

European Patent Office

Office européen des brevets

(19)

(11) Veröffentlichungsnummer : **0 125 571**
**B1**

(12) **EUROPÄISCHE PATENTSCHRIFT**

(45) Veröffentlichungstag der Patentschrift :
**02.11.89**

(21) Anmeldenummer : **84105002.4**

(22) Anmeldetag : **03.05.84**

(51) Int. Cl.⁴.: **H 01 L 29/72**, H 01 L 27/08,
H 01 L 21/00

(54) **Planartransistor mit niedrigem Rauschfaktor und Verfahren zu dessen Herstellung.**

(30) Priorität : **13.05.83 DE 3317437**

(43) Veröffentlichungstag der Anmeldung :
**21.11.84 Patentblatt 84/47**

(45) Bekanntmachung des Hinweises auf die Patenterteilung : **02.11.89 Patentblatt 89/44**

(84) Benannte Vertragsstaaten :
**DE FR GB IT NL**

(56) Entgegenhaltungen :
**EP-A- 0 071 665**
**DE-A- 1 464 718**
**FR-A- 2 148 175**
**INTERNATIONAL ELECTRON DEVICES MEETING 1979, TECHNICAL DIGEST, 1979, Seiten 514-517, IEEE, New York, US; G. DAS et al.: "Emitter compensation effect"**
**ELECTRONIC ENGINEERING, Band 45, August 1973, Seiten 44-46, London, GB; L.S. CORNISH: "Transistor base-emitter junction protection improves reliability"**

(73) Patentinhaber : **Deutsche ITT Industries GmbH**
**Hans-Bunte-Strasse 19 Postfach 840**
**D-7800 Freiburg (DE)**

**ITT INDUSTRIES INC.**
**320 Park Avenue**
**New York, NY 10022 (US)**

(72) Erfinder : **Blossfeld, Lothar, Dipl.-Phys.**
**Waldstrasse 23**
**D-7801 Freiburg-Hochdorf (DE)**

(74) Vertreter : **Klunker . Schmitt-Nilson . Hirsch**
**Winzererstrasse 106**
**D-8000 München 40 (DE)**

## Beschreibung

Die Erfindung betrifft einen Planartransistor mit niedrigem Rauschfaktor, dessen in ein halbleitendes Substrat vom Kollektorleitungstyp eingebrachte Basiszone aus einem relativ schwach dotierten inneren Basiszonenteil unter der mit einem Emitterkontakt versehenen Emitterzone und einem den inneren Basiszonenteil kontaktierenden relativ stark dotierten dicken äußeren Basiszonenteil besteht, an dem der Basiskontakt angebracht ist. Ein solcher Planartransistor ist aus der US-PS 34 84 309 und der DE-AS 14 89 234 bekannt.

Es wurde festgestellt, daß bei der Fertigung dieser Planartransistoren die Rauschfaktoren ebenfalls gewissen Schwankungen unterworfen sind und daß insbesondere bei besonders rauscharmen Exemplaren eine wesentliche Verschlechterung der Rauschfaktoren auftreten kann, wenn der Emitter-Basis-PN-Übergang kurzzeitig in den Zenerdurchbruch gerät, was auch ungewollt in gleicher Weise wie bei MOS-Feldeffekttransistoren aufgrund statischer Aufladungen geschehen kann, falls der Emitter-Basis-PN-Übergang einen entsprechenden sehr geringen Sperrstrom aufweist.

Die Erfindung geht daher von der Erkenntnis aus, daß rauscharme bipolar Planartransistoren zur Erhaltung ihrer Rauscharmut gegen den Zenerdurchbruch des Emitter-Basis-PN-Übergangs geschützt werden müssen.

Aufgabe der Erfindung ist daher die Angabe eines rauscharmen Planartransistors, dessen Rauscharmut auch dann erhalten bleibt, falls die Emitter-Basis-Spannung die Zenerdurchbruchspannung des Emitter-Basis-PN-Übergangs überschreitet.

Diese Aufgabe wird erfindungsgemäß dadurch gelöst, daß zum Schutze des Emitter-Basis-PN-Übergangs gegen Zenerdurchbruch in das Substrat eine weitere Basiszone und darin eine weitere Emitterzone einer Schutztransistorstruktur eingesetzt ist und daß die Basiszone mit der weiteren Emitterzone über einen Teil des Basiskontaktes und die Emitterzone mit der weiteren Basiszone über einen Teil des Emitterkontaktes elektrisch verbunden sind.

Aus « Electronic Engineering » (Aug. 1973) Seiten 44 bis 46, ist zwar bekannt, die Emitter-Basis-Strecke eines PNP-Si-Planartransistors gegen einen Durchbruch mittels einer Diode zu schützen. Diese Maßnahme erfolgt aber zur Verhinderung der Verschlechterung der Gleichstromverstärkung eines Leistungstransistors und nicht zur Verhinderung einer Verschlechterung der Rauscheigenschaften eines rauscharmen Planartransistors. Außerdem ist die Diode bei der bekannten Schaltungsanordnung nicht im Halbleiterkörper des Transistors integriert.

Die Erfindung ist mit größtem Vorteil anwendbar bei einem Planartransistor, der eine nichtkompensierte Emitterzone und eine Basiszone aufweist, die aus einem aktiven relativ schwach dotierten inneren Basiszonenteil und aus einem den inneren Basiszonenteil kontaktierenden dicken nicht aktiven äußeren Zonenteil besteht, der relativ stark dotiert ist. Bei einem Planartransistor mit nichtkompensierter Emitterzone, wie er aus « International Electron Devices Meeting 1979, Technical Digest » Seiten 514 bis 517, bekannt ist, wurde festgestellt, daß dieser besonders rauscharm ist, so daß die relative Verschlechterung der Rauscheigenschaften bei einem Durchbruch des Emitter-Basis-PN-Übergangs sich bei einem solchen Planartransistor besonders bemerkbar macht.

Demzufolge ist die Erfindung mit größtem Vorteil anwendbar bei einem Verfahren, welches Planartransistoren mit nichtkompensierten Emitterzonen herzustellen gestattet, beispielsweise nach dem bekannten Verfahren der europäischen Patentanmeldung 0 071 665. Eine Weiterbildung der Erfindung bezieht sich daher auf ein Verfahren, bei dem gemäß dem Verfahrensanspruch 3 der Erfindung in Abwandlung des bekannten Verfahrens vorgegangen wird und ein nichtintegrierter Planartransistor in einem als Kollektorzone dienenden Substratkörper hergestellt wird, so daß die Arbeitsprozesse zur Herstellung der Kollektorzone unter Anwendung einer maskierten Ionenimplantation entfallen.

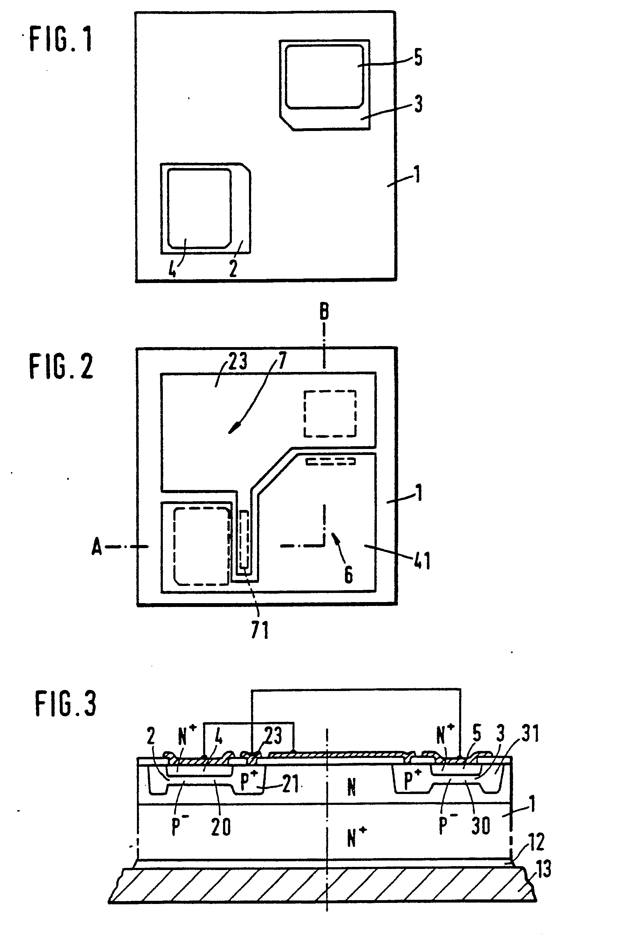

Die Erfindung und das bevorzugte Herstellungsverfahren werden im folgenden anhand der Zeichnung erläutert,

deren Fig. 1 die Aufsicht auf einen plättchenförmigen Substratkörper eines Planartransistors im Stadium unmittelbar nach der Diffusion der Zonen zeigt,

deren Fig. 2 die Aufsicht auf dessen Substratkörper nach der Kontaktierung der Zonen und deren Verschaltung veranschaulicht und

deren Fig. 3 eine Schnittansicht entlang der geknickten Schnittlinie A-B der Fig. 2 bedeutet.

Die Herstellung des Planartransistors nach der Erfindung erfolgt an einer in die einzelnen Planartransistoren zu zerteilenden Halbleiterplatte und wird im folgenden beschrieben. Beim Verfahren nach der Erfindung werden in Abwandlung des bekannten Verfahrens nach der europäischen Patentanmeldung 0 071 665 auf der einen Oberflächeseite eines plattenförmigen Halbleitersubstrats 1 des Kollektorleitungstyps die Emitterzonenbereiche der Emitterzonen 4 und 5 mit je einer Oxidationsmaskierungsschicht bedeckt. Zu diesem Zweck werden zunächst auf der gesamten Oberflächenseite eine vorzugsweise aus einer unteren Siliziumdioxidschicht und einer oberen Siliziumnitridschicht bestehende Oxidationsmaskierungsschicht aufgebracht und aus dieser unter Anwendung eines photolithographischen Ätzprozesses die Oxidationsmaskierungsschichten herausgeätzt, welche die Emitterzonenbereiche bedecken. Die Gesamtdicke der Oxidationsmaskierungsschicht wird so bemessen, daß sie bei einem ersten Ionenimplantationsprozess von Ionen des

Basisleitungstyps relativ geringer Dosis durchdringbar ist und gegen die Ionen bei einem zweiten Ionenimplantationsprozess von Ionen des gleichen Leitungstyps und mit relativ großer Dosis maskierend wirkt. Anschließend wird eine Fotolackschicht aufgebracht und diese durch eine Fotomaske derartiger Struktur belichtet, daß die Substratoberfläche außerhalb der Bereiche der Basiszonen 2 und 3 gegen die anschließend in beliebiger Reihenfolge erfolgenden beiden Implantationsprozesse gegen eine Implantation maskiert ist.

Die als Implantationsmaske verwendete Fotolackmaske wird danach sorgfältig entfernt, und die Bereiche der äußeren Basiszonen 21 und 31 sowie die Bereiche außerhalb der Basiszonen 2 und 3 werden durch thermische Oxidation mit einer Ätzmaskierungsschicht solcher Dicke bedeckt, daß sie bei der folgenden Implantation von Dotierungen der Emitterzonen als Ionenimplantationsmaske verwendet werden kann. Es erfolgt sodann ein Nitridätzprozeß, beispielsweise mit heißer Phosphorsäure als Ätzmittel, wobei die obere Teilschicht der Oxidationsmaskierungsschichten entfernt wird, und anschließend ein Ätzprozeß unter Verwendung einer der üblichen Ätzmittel zum Ätzen von Siliziumdioxid. Dieser Ätzprozeß wird solange durchgeführt, bis die untere Teilschicht der Oxidationsmaskierungsschicht entfernt ist. Dabei wird die aus thermisch erzeugtem Siliziumdioxid bestehende Ätzmaskierungsschicht nur geringfügig hinsichtlich der Dicke angelöst. Auf diese Weise wird eine aus thermisch gewachsenem Siliziumdioxid bestehende Implantationsmaske erhalten, deren Maskenöffnungen auf die äußeren Basiszonen 21 und 31 (vergleiche Fig. 3) ausgerichtet sind. Es erfolgt nun ein Implantationsprozeß der Dotierungen der Emitterzonen 4 und 5 in die freigelegten Teile der Substratoberfläche. Die Fig. 1 zeigt in Aufsicht einen Planartransistorbereich nach der Aktivierung der Dotierungen bei einer Diffusionstemperatur.

Aus der Fig. 3 ist zunächst einmal ersichtlich, daß sowohl die Basis 2 des Planartransistors als auch die Basiszone 3 der Schutztransistorstruktur je einen inneren Basiszonenteil 20 bzw. 30 und je einen stark dotierten dickeren äußeren Zonenteil 21 bzw. 31 aufweisen.

Aufgrund der Eigentümlichkeit des Implantationsprozesses bleibt der Teil, der von der Emitterzone 4 eingenommen wird, weitgehend frei von Dotierungen, so daß ein besonders niedriger Rauschfaktor aufgrund der nichtkompensierten Emitterzone 4 erhalten wird. An sich ist eine derartige Emitterzone bei der Schutztransistorstruktur mit der Emitterzone 5 nicht erforderlich.

Nach der Diffusion der Zonen 2 bis 5 gemäß der Fig. 1 werden an der Emitterzone 4 ein Emitterkontakt 41, der diese mit der weiteren Basiszone 3 verbindet, und an der Basiszone 2 ein Basiskontakt 23 angebracht, der die Basiszone 2 mit der weiteren Emitterzone 5 verbindet. Dies erfolgt in üblicher Weise, indem aus einer auf der Anordnung aufgebrachten Leitschicht unter Anwendung eines photolithographischen Ätzprozesses der Basiskontakt 23 und der Emitterkontakt 41 herausgeätzt werden. Nach der Aufsicht der Fig. 2 weist der Basiskontakt 23 einen streifenförmigen Kontaktteil 71 auf, der in eine Einbuchtung des Emitterkontaktes 41 ragt. Beide Kontakte 23 und 41 weisen Kontaktierungsteile 6 und 7 auf, welche diagonal zueinander auf der Oberfläche des rechteckigen Halbleiterplättchens angeordnet sind. Deren Flächen werden derart bemessen, daß an ihnen je ein Thermokompressions-Kontakt eines Kontaktierungsdrahtes angebracht werden kann.

Nach Aufteilung der Halbleiterplatte in die einzelnen Halbleiterplättchen, welche die Kollektorzone bilden, werden die Halbleiterplättchen mit dem hochdotierten Substratteil über einen leitfähigen Kleber bzw. mit einem Lot 12 auf dem Kollektor-Leiterstreifen 13 befestigt.

## Patentansprüche

1. Planartransistor mit niedrigem Rauschfaktor, dessen in ein halbleitendes Substrat (1) vom Kollektorleitungstyp eingebrachte Basiszone (2) aus einem relativ schwach dotierten inneren Basiszonenteil (20) unter der mit einem Emitterkontakt (41) versehenen Emitterzone (4) und einem den inneren Basiszonenteil (20) kontaktierenden relativ stark dotierten dickeren äußeren Basiszonenteil (21) besteht, an dem der Basiskontakt (23) angebracht ist, dadurch gekennzeichnet,

daß zum Schutze des Emitter-Basis-PN-Übergangs gegen Zenerdurchbruch in das Substrat (1) eine weitere Basiszone (3) und darin eine weitere Emitterzone (5) einer Schutztransistorstruktur eingesetzt ist und

daß die Basiszone (2) mit der weiteren Emitterzone (5) über einen Teil des Basiskontaktes (23) und die Emitterzone (4) mit der weiteren Basiszone (3) über einen Teil des Emitterkontaktes (41) elektrisch verbunden sind.

2. Planartransistor nach Anspruch 1, dadurch gekennzeichnet,

daß der Basiskontakt (23) einen streifenförmigen Kontaktteil (71) aufweist, der in eine Einbuchtung des Emitterkontaktes (41) ragt, und

daß beide Kontakte mit Kontaktierungsteilen (6, 7) versehen sind, welche diagonal zueinander auf der Oberflächenseite eines rechteckigen Halbleiterplättchens angeordnet sind und deren Flächen zur Anbringung von Thermokompressions-Verbindungen an Kontaktierungsdrähten bemessen sind.

3. Verfahren zum Herstellen eines Planartransistors nach Anspruch 1, dadurch gekennzeichnet,

daß auf der einen Oberflächenseite eines Substrats (1) des Kollektorleitungstyps die Emitterzonenbereiche der Emitterzonen (4, 5) mit je einer Oxidationsmaskierungsschicht bedeckt werden, wobei die Dicke der Oxidationsmaskierungsschicht so bemessen ist, daß sie bei einem ersten Ionenimplantationsprozeß relativ niedriger Dosis von Ionen des Basisleitungstyps durchdrungen wird und gegen die Ionen relativ hoher Dosis bei einem zweiten Ionenimplantationsprozeß von Ionen des Basisleitungstyps maskierend wirkt,

daß dann in beliebiger Reihenfolge die beiden Implantationsprozesse erfolgen, wobei die Substratoberfläche außerhalb der Bereiche der Basiszonen (2, 3) gegen eine Implantation von Ionen während der beiden Implantationsprozesse mittels einer Implantationsmaske maskiert ist,

daß danach nach Entfernung der Implantationsmaske die Bereiche der äußeren Basiszone (21, 31) und die Bereiche außerhalb der Basiszonen (2, 3) durch thermische Oxidation mit einer Ätzmaskierungsschicht einer solche Dicke bedeckt werden, daß sie als Ionenimplantationsmaske bei dem noch zu erfolgenden Emitter-Implantationsprozeß wirksam ist,

daß dann die Oxidationsmaskierungsschichten mit einem solchen Ätzmittel entfernt werden, daß die Ätzmaskierungsschicht höchstens geringfügig hinsichtlich der Dicke angelöst wird,

daß anschließend in die freiliegende Substratoberfläche Ionen der Dotierungen der Emitterzonen (4, 5) implantiert werden und dann sowohl die Basiszonen (2, 3) als auch die Emitterzonen (4, 5) unter Aktivierungen der Dotierungen diffundiert werden und

daß danach ein Emitterkontakt (41) an der Emitterzone (4), der diese mit der weiteren Basiszone (3) verbindet, und an der Basiszone (2) ein Basiskontakt (23) angebracht werden, der die Basiszone (2) mit der weiteren Emitterzone (5) verbindet.

## Claims

1. Planar transistor having a low noise factor, whose base region (2) as introduced into a semiconducting substrate (1) of the conductivity type of the collector, consists of a relative weakly doped inner base-region portion (20) below the emitter region (4) provided which the emitter contact (41) and of a relative strongly doped thicker outer base-region portion (21) contacting the inner base region portion (20), to which the base contact (23) is attached, characterized in

that for protection of the emitter-base-pn-boundary against Z-breakdown into said substrate (1) there is introduced a further base region (3) and, therein, a further emitter region (5) of a protection transistor structure, and

that said base region (2) is electrically connected to said further emitter region (5) via a portion of the base contact (23) while the emitter region (4) is electrically connected to said further base region (3) via a portion of the emitter contact (41).

2. A planar transistor as claimed in claim 1, characterized in

that said base contact (23) comprises a strip-shaped contact portion portion (71) which projects into an embayment of said emitter contact (41), and

that both contacts are provided with contacting members (6, 7) which are disposed diagonally in relation to one another on the surface side of a rectangular semiconductor chip, with the surface areas thereof being so dimensioned as to permit the attachment of thermocompression connections to the contacting wires.

3. A process for manufacturing a planar transistor as claimed in claim 1, characterized in

that on the one surface side of a substrate (1) of the collector conductivity type, the emitter region areas of said emitter regions (4, 5) are each covered with an oxidation masking layer, with the thickness of said oxidation masking layer being so dimensioned that it, in the course of a first relatively low-dose ion implantation process, is penetrated by ions of the base conductivity type and has a masking effect with respect to the ions of a relatively high-dose second ion implantation process of ions of the base conductivity type,

that then in an optional order of succession, there are carried out the two implantation processes, with the substrate surface outside the areas of said base regions (2, 3) being masked against an implantation of ions during the two implantation processes, with the aid of an implantation mask,

that then, following the removal of the implantation mask, the areas of the outer base region (21, 31) and the areas outside the base regions (2, 3) are covered, by way of thermal oxidation, with an etch masking layer of such thickness that it is effective as an ion implantation mask in the course of the emitter implantation process still to be carried out,

that thereafter said oxidation masking layers are removed by employing such an etching agent that the etch masking layer in the utmost is slightly dissolved with respect to its thickness,

that thereafter, into the exposed substrate surface, ions of the dopings of the emitter regions (4, 5) are implanted, and that then said base regions (2, 3) as well as said emitter regions (4, 5) are diffused by way of activating the dopings and,

that finally an emitter contact (41) is attached to said emitter region (4) for connecting the latter to said further base region (3), and that also to said base region (2) there is attached a base contact (23) for connecting said base region (2) to said further emitter region (5).

## Revendications

1. Transistor planar à faible facteur de bruit, dont la zone de base (2) encastrée dans un substrat (1) semi-conducteur du type de conductivité d'un collecteur est constituée d'une partie intérieure de zone de base (20) à dopage relativement faible, située en dessous de la zone d'émetteur (4) munie d'un contact d'émetteur (41), et d'une partie extérieure de zone de base (21) plus épaisse à dopage relativement important, entrant en contact avec la partie intérieure de zone de base, sur laquelle le contact de base (23) est agencé, caractérisé en ce que :

pour protéger la jonction PN émetteur-base contre le claquage par effet Zener, une zone de base additionnelle (3) est introduite dans le substrat et, dans celle-ci, une zone d'émetteur additionnelle (5) d'une structure de transistor de protection, et

la zone de base (2) est reliée électriquement avec la zone d'émetteur additionnelle (5) par une partie du contact de base (23) et la zone d'émetteur (4) l'est avec la zone de base additionnelle (3) par une partie du contact d'émetteur (4).

2. Transistor planar selon la revendication 1, caractérisé en ce que :

le contact de base (23) présente une partie de contact en forme de bande (71) qui s'engage dans un évidement du contact d'émetteur (41), et

les deux contacts sont munis de parties de contact (6, 7) qui sont agencées en diagonale l'une par rapport à l'autre sur le côté de la surface d'une plaquette de semiconducteur rectangulaire et en ce que leurs surfaces sont calculées pour la pose de liaisons de thermocompression sur des fils de contacts.

3. Procédé de fabrication d'un transistor planar selon la revendication 1, caractérisé en ce que :

sur un côté de la surface d'un substrat (1) du type de conductivité d'un collecteur, les régions des zones d'émetteur (4, 5) sont recouvertes chacune d'une couche de masquage d'oxydation, l'épaisseur de la couche de masquage d'oxydation étant calculée de manière à être, lors d'un premier processus d'implantation ionique à dosage relativement faible, pénétrée par des ions du type de conductivité de base et à avoir un effet de masquage contre les ions à dosage relativement plus élevé lors d'un second processus d'implantation ionique d'ions du même type de conductivité,

les deux processus d'implantation ont lieu ensuite en ordre quelconque, la surface du substrat en dehors des régions des zones de base (2, 3) étant masquée contre une implantation d'ions pendant ces deux processus d'implantation au moyen d'un masque d'implantation,

après l'élimination du masque d'implantation, les régions de la zone de base extérieure (21, 41) et les régions en dehors des zones de base (2, 3) sont recouvertes, par oxydation thermique, d'une couche de masquage d'attaque d'une épaisseur telle qu'elle fait fonction de masque d'implantation ionique au cours du processus d'implantation d'émetteur qui a lieu ensuite,

les couches de masquage d'oxydation sont ensuite éliminées par un agent d'attaque tel la couche de masquage d'attaque perd extrêmement peu de son épaisseur,

ensuite les ions des dopages des zones d'émetteur (4, 5) sont implantés dans la surface du substrat dégagée et les zones de base (2, 3) ainsi que les zones d'émetteur (4, 5) sont diffusées par activation des dopages, et

sont ensuite posés sur la zone d'émetteur (4) un contact d'émetteur (41), qui relie celle-ci à la zone de base additionnelle (3), et sur la zone de base (2) un contact de base (23) qui relie la zone de base (2) avec la zone d'émetteur additionnelle (5).

FIG.1

FIG.2

FIG.3